# EUROPÄISCHE PATENTSCHRIFT

(11) **EP 2 733 500 B1**
(45) Veröffentlichungstag und Bekanntmachung des Hinweises auf die Patenterteilung: **30.12.2015**
(21) Anmeldenummer: 13004911.7
(22) Anmeldetag: 14.10.2013
(51) Int. Cl.: G01R 33/36, G01F 1/716, G01F 1/74, G01N 24/08

(54) **Messsystem für kernmagnetische Messgeräte**
Measuring system for nuclear magnetic measuring devices
Système de mesure pour appareils de mesure à noyau magnétique

(30) Priorität: 14.11.2012 DE 102012022242; 07.03.2013 DE 102013003836
(43) Veröffentlichungstag der Anmeldung: 21.05.2014
(73) Patentinhaber: Krohne AG, 4019 Basel (CH)
(72) Erfinder: Hofstede, Jan Johannes Jacobus, 2803 SX Gouda (NL); Bergkamp, Erwin Johannes Gerardus, 3708 DA Zeist (NL)
(74) Vertreter: Gesthuysen Patent- und Rechtsanwälte

(56) Entgegenhaltungen:
- DE-A1- 3 815 419
- US-A- 5 903 150
- US-A1- 2006 020 403
- US-A1- 2012 001 629
- Chen C.-N., Hoult, D. I.: "Biomedical Magnetic Resonance Technology", 1989, Adam Hilger, Bristol and New York, XP002721493, ISBN: 0-85274-118-9 Seiten 210-213, * Abbildung 5.23 * * *

## Beschreibung

Die Erfindung betrifft Messsystem für kernmagnetische Messgeräte mit einer Steuerung, einem Signalgenerator zum Erzeugen und Ausgeben von elektrischen Anregungssignalen und einer Signalverarbeitung mit einer Eingangsstufe und einer auf die Eingangsstufe im Signalpfad der Signalverarbeitung folgenden Signalkonditionierung zur Verarbeitung der von den Anregungssignalen sₐ hervorgerufenen und am Eingang der Eingangsstufe eingehenden elektrischen Messsignale sₑ, wobei auch von den Anregungssignalen sₐ hervorgerufene und nicht zeitgleich mit den Messsignalen sₑ auftretende Störsignale sₛ am Eingang der Eingangsstufe eingehen_können, der Signalhub der Messsignale sₑ kleiner ist als der Signalhub der Störsignale sₛ und die Steuerung die Zeitpunkte des Ausgebens der Anregungssignale sₐ bestimmt, wobei im Signalpfad der Signalverarbeitung zwischen dem Ausgang der Eingangsstufe und dem Eingang der Signalkonditionierung ein Schalter angeordnet ist, der Schalter durch die Steuerung in einen ersten Schaltzustand I und einen zweiten Schaltzustand II schaltbar ist, im ersten Schaltzustand I das Signal am Ausgang der Eingangsstufe an den Eingang der Signalkonditionierung geleitet ist und im zweiten Schaltzustand II das Signal am Ausgang der Eingangsstufe nicht an den Eingang der Signalkonditionierung geleitet ist, und wobei die Steuerung ausgebildet ist, den Schalter nur in den Zeiträumen in den ersten Schaltzustand I zu schalten, in denen keine Störsignale am Eingang der Eingangsstufe anliegen, und dass der Aussteuerbereich des Eingangs der Signalkonditionierung an den Spannungshub der Messsignale angepasst ist.

Ein derartiges Messsystem ist aus der Druckschrift DE 38 15 419 A1 bekannt.

Die Atomkerne der Elemente, die einen Kernspin besitzen, besitzen auch ein durch den Kernspin hervorgerufenes magnetisches Moment. Der Kernspin kann als ein durch einen Vektor beschreibbarer Drehimpuls aufgefasst werden, und entsprechend kann auch das magnetische Moment durch einen Vektor beschrieben werden, der parallel zum Vektor des Drehimpulses ausgerichtet ist. Der Vektor des magnetisches Moments eines Atomkerns richtet sich bei Anwesenheit eines makroskopischen Magnetfelds parallel zu dem Vektor des makroskopischen Magnetfelds an der Stelle des Atomkerns aus. Dabei präzessiert der Vektor des magnetischen Moments des Atomkerns um den Vektor des makroskopischen Magnetfelds an der Stelle des Atomkerns. Die Frequenz der Präzession wird als Larmorfrequenz ω_{L} bezeichnet und ist proportional zum Betrag der Magnetfeldstärke *B*. Die Larmorfrequenz berechnet sich gemäß ω_{L} = γ · *B*. Darin ist γ das gyromagnetische Verhältnis, welches für Wasserstoffkerne maximal ist. Kernmagnetische Messgeräte implementieren kernmagnetische Resonanz-Messverfahren. Diese Messverfahren beeinflussen die Präzession von Atomkernen eines Mediums bei Anwesenheit eines makroskopischen Magnetfelds durch Anregung mittels eines gesteuerten Magnetfelds und werten die Wirkung der Beeinflussung aus. Für gewöhnlich wird die Präzession der Atomkerne durch das Messsystem beeinflusst, indem die elektrischen Anregungssignale sₐ erzeugt werden. Diese elektrischen Anregungssignale sₐ können in einer Sendespule in magnetische Anregungssignale umgewandelt werden, welche die Präzession der Atomkerne beeinflussen. Die von den angeregten präzessierenden Atomkernen für gewöhnlich in eine Sensorspule induzierten elektrischen Signale werden als Ausgangsgröße für die Messverfahren verwendet. Oftmals wird nur eine einzige Spule sowohl als Sendespule als auch Empfangsspule eingesetzt.

Ein Beispiel für kernmagnetische Messgeräte sind kernmagnetische Durchflussmessgeräte für mehrphasige Medien, die den Durchfluss, das sind die Strömungsgeschwindigkeiten der einzelnen Phasen eines Mediums und die relativen Anteile der einzelnen Phasen am mehrphasigen Medium, messen können. Voraussetzung für die Messung eines mehrphasigen Mediums ist, dass die einzelnen Phasen des Mediums zu unterscheidbaren kernmagnetischen Resonanzen angeregt werden können. Kernmagnetische Durchflussmessgeräte können z. B. zur Durchflussmessung des aus Ölquellen geförderten mehrphasigen Mediums eingesetzt werden. Dieses Medium besteht im Wesentlichen aus den flüssigen Phasen Rohöl und Salzwasser und der gasförmigen Phase Erdgas, wobei alle Phasen die für kernmagnetische Resonanzen notwendigen Wasserstoffkerne enthalten und zu unterschiedlichen kernmagnetischen Resonanzen anregbar sind.

Die Messung des aus Ölquellen geförderten Mediums kann auch mit Testseparatoren erfolgen. In Testseparatoren wird das geförderte Medium über einen Zeitraum eingeleitet und sie trennen die einzelnen Phasen des Mediums voneinander und bestimmen die Anteile der einzelnen Phasen an dem Medium. Jedoch sind Testseparatoren, im Gegensatz zu kernmagnetischen Durchflussmessgeräten, nicht im Stande, Rohölanteile kleiner als 5 % zuverlässig zu messen. Da der Rohölanteil einer jeden Quelle stetig absinkt und der Rohölanteil einer Vielzahl von Quellen bereits geringer als 5 % ist, ist es derzeit nicht möglich, diese Quellen unter Verwendung von Testseparatoren wirtschaftlich auszubeuten. Um auch Quellen mit einem sehr geringen Rohölanteil weiterhin ausbeuten zu können, sind entsprechend genaue Durchflussmessgeräte für das aus mehreren Phasen bestehende Medium Rohöl erforderlich. Hiefür kommen insbesondere kernmagnetische Durchflussmessgeräte infrage.

Für eine hohe Messgenauigkeit des Messsystems ist die Anpassung des von der Signalverarbeitung verarbeitbaren maximalen Signalhubs an den maximalen Signalhub der Messsignale sₑ erforderlich. Denn ist der maximale Signalhub der Messsignale sₑ kleiner als der maximale von der Signalverarbeitung verarbeitbare Signalhub, sinkt die Messgenauigkeit. Jedoch empfängt die Sensorspule nicht nur die von den Anregungssignalen sₐ hervorgerufenen Messsignale sₑ, sondern auch die von den Anregungssignalen sₐ hervorgerufenen Störsignale sₛ. Diesen Störsignalen sₛ ist gemein, dass sie nicht zeitgleich mit den Messsignalen sₑ auftreten und der Signalhub größer ist als der Signalhub der Messsignale sₑ. Zu diesen Störsignalen sₛ gehören auch die Anregungssignale sₑ selbst. Wenn nur eine einzige Spule sowohl zum Senden der Anregungssignale als auch zum Empfangen der Messsignale verwendet wird, sind Störsignale sₛ gleich den Anregungssignalen sₐ.

Folglich ist der von der Signalverarbeitung verarbeitbare maximale Signalhub entweder an den maximalen Signalhub der Störsignale sₛ anzupassen oder der maximale Signalhub am Eingang der Signalverarbeitung zu begrenzen. Bei der Anpassung des von der Signalverarbeitung verarbeitbaren maximalen Signalhubs an den maximalen Signalhub der Störsignale sₛ wird allerdings die Messgenauigkeit reduziert. Aus dem Stand der Technik ist die Begrenzung des maximalen Signalhubs am Eingang der Signalkonditionierung durch eine Schaltung mit Dioden bekannt. Da die Flussspannung von Dioden aber größer ist als der Signalhub der Messsignale sₑ, ist der von der Signalverarbeitung verarbeitbare maximale Signalhub an die Flussspannung der Dioden anzupassen und nicht an den maximalen Signalhub der Messsignale sₑ. Auch bei dieser Lösung wird die Messgenauigkeit reduziert.

Aufgabe der vorliegenden Erfindung ist daher, ein Messsystem anzugeben, das eine Anpassung des von der Signalverarbeitung verarbeitbaren maximalen Signalhubs an den maximalen Signalhub der von den Anregungssignalen sₐ hervorgerufenen Messsignale sₑ ermöglicht.

Das erfindungsgemäße Messsystem ist in Anspruch 1 definiert. Es ist dadurch gekennzeichnet, dass der Schalter ein einpoliger Wechselschalter mit einem Mittelanschluss, einem ersten Anschluss und einem zweiten Anschluss ist, wobei der Mittelanschluss mit dem Eingang der Signalkonditionierung verbunden ist, der erste Anschluss mit dem Ausgang der Eingangsstufe zur Leitung des Signals am Ausgang der Eingangsstufe an den Eingang der Signalkonditionierung im ersten Schaltzustand verbunden ist und der zweite Anschluss über einen ohmschen Spiegelwiderstand mit einm konstanten Potential zur Verbindung des Eingangs der Signalkonditionierung mit dem Spiegelwiderstand im zweiten Schaltzustand verbunden ist.

Der erfindungsgemäß vorgesehene Schalter ermöglicht die genaue Anpassung des von der Signalverarbeitung verarbeitbaren maximalen Signalhubs an den maximalen Signalhub der Messsignale sₑ. Im Gegensatz zur aus dem Stand der Technik bekannten Schaltung mit Dioden handelt es sich nicht um einen passiv, sondern um einen aktiv gesteuerten Ansatz, wobei die Implementierung des Schalters PIN-Dioden als Schaltelemente umfassen kann. Der passive Ansatz mit Dioden hat den weiteren Nachteil, dass der Anstieg des Stroms durch die Diode mit steigender Spannung nur eine begrenzte Steilheit aufweist. Demnach können im Unterschied zum erfindungsgemäßen aktiven Ansatz nicht Störsignale mit beliebig hohen Signalhüben vom Eingang der Signalverarbeitung ferngehalten werden.

Gemäß einer bevorzugten Ausgestaltung des erfindungsgemäßen Messsystems sind die Zeiträume, in denen die Störsignale sₛ nicht am Eingang der Eingangsstufe anliegen, unter Berücksichtigung des Zeitraums zwischen dem Zeitpunkt des Ausgebens eines der Anregungssignale sₐ aus dem Signalgenerator und dem Zeitpunkt des Eintreffens des von dem Anregungssignal sₐ hervorgerufenen Störsignals sₛ am Eingang der Eingangsstufe bestimmt. Ein von dem Signalgenerator erzeugtes und ausgegebenes elektrisches Anregungssignal sₐ beeinflusst die Präzession der Atomkerne. Die von diesem Anregungssignal sₐ beeinflusste Präzession wird in einem Messsignal sₑ festgehalten. Da der Zeitraum zwischen dem Ausgeben eines elektrischen Anregungssignals sₐ und dem Eingang des dazugehörigen Messsignals sₑ stets konstant ist, ist der Schalter nur dann in den ersten Schaltzustand I geschaltet, wenn nur das Messsignal sₑ am Eingang der Signalkonditionierung anliegt. Auf diese Weise sind die Störsignale sₛ am Eingang der Eingangsstufe von der Signalkonditionierung ferngehalten.

Gemäss der Erfindung ist der Schalter ein einpoliger Wechselschalter mit einem Mittelanschluss, einem ersten Anschluss und einem zweiten Anschluss. Der Mittelanschluss ist mit dem Eingang der Signalkonditionierung verbunden, der erste Anschluss ist mit dem Ausgang der Eingangsstufe zur Leitung des Signals am Ausgang der Eingangsstufe an dem Eingang der Signalkonditionierung im ersten Schaltzustand I verbunden und der zweite Anschluss ist über einen ohmschen Spiegelwiderstand mit einem konstanten Potential zur Verbindung des Eingangs der Signalkonditionierung mit dem Spiegelwiderstand im zweiten Schaltzustand II verbunden. Das konstante Potential kann insbesondere das Massepotential sein. Als einpolige Wechselschalter können aus dem Stand der Technik bekannte handelsübliche Halbleiterschalter verwendet sein, welche durch die Steuerung angesteuert sind. Durch entsprechende Steuersignale kann die Steuerung den Wechselschalter entweder in den ersten Schaltzustand I oder in den zweiten Schaltzustand II bringen.

Der in dem erfindungsgemäßen Messsystems vorgesehene Spiegelwiderstand gewährleistet, dass der Eingang der Signalkonditionierung auch im zweiten Schaltzustand II abgeschlossen ist, so dass keine Störsignale am Eingang der Signalkonditionierung entstehen können. Mit dem Schalter im zweiten Schaltzustand II und ohne den Spiegelwiderstand wäre der Eingang der Signalkonditionierung hochohmig und Einstreuungen könnten das Potential des Eingangs signifikant beeinflussen. Durch den Spiegelwiderstand werden Einstreuungen abgeleitet.

Vorzugsweise ist auch der Signalpfad der Eingangsstufe über einen ohmschen Abschlusswiderstand derart mit einem konstanten Potential verbunden, dass der Eingangswiderstand der Eingangsstufe dem Widerstandswert des Abschlusswiderstands entspricht. Das konstante Potential kann insbesondere das Massepotential sein. Der Widerstandswert des Abschlusswiderstands kann gleich dem Leitungswellenwiderstand der Signalquelle gewählt werden, welche das Messsignal sₑ dem Eingang der Eingangsstufe zuführt. Auf diese Weise werden Reflektionen des Messsignals sₑ am Eingang der Eingangsstufe vermieden.

Bevorzugt sind der Widerstandswert des Spiegelwiderstands und der Widerstandswert des Abschlusswiderstands derart gewählt, dass der Widerstandswert am Mittelanschluss des Wechselschalters unabhängig vom Schaltzustand ist. Durch den Umstand, dass der Signaleingang der Signalkonditionierung unabhängig vom Schaltzustand des Wechselschalters immer mit dem gleichen Widerstandswert abgeschlossen ist, können Störungen am Signaleingang der Signalkonditionierung besonders gut vermieden werden. Benötigt der Signaleingang beispielsweise einen konstanten Gleichstrom, so würden unterschiedliche Widerstandswerte für den Spiegelwiderstand und den Abschlusswiderstand zu unterschiedlichen Potentialen des Signaleingangs in Abhängigkeit des Schaltzustands führen.

Leitungen mit einem Leitungswellenwiderstand von 50 Ohm sind weit verbreitet, weshalb es sich anbietet, die Leitung am Eingang der Eingangsstufe abzuschließen, indem der Widerstandswert des Abschlusswiderstands 50 Ohm beträgt. Auf diese Weise werden Reflexionen des Messsignals sₑ am Eingang der Eingangsstufe vermieden. Infolgedessen ist es ebenfalls vorteilhaft, auch den Widerstandswert des Spiegelwiderstands zu 50 Ohm zu wählen.

In einer weiteren bevorzugten Ausgestaltung des erfindungsgemäßen Messsystems weist die Signalkonditionierung im Signalpfad einen Tiefpassfilter und einen Verstärker auf. Der Tiefpassfilter ist im Signalpfad zwischen dem Eingang der Signalkonditionierung und dem Eingang des Verstärkers angeordnet und zur Dämpfung von durch das Schalten des Schalters hervorgerufenen Störungen ausgebildet. Auch wenn sowohl der Widerstandswert des Spiegelwiderstands als auch der Widerstandswert des Abschlusswiderstands optimal gewählt sind, kann es dennoch durch das Schalten des Schalters selbst zu Störungen am Signaleingang der Signalkonditionierung kommen. Diesen Störungen ist jedoch gemein, dass sie im Wesentlichen ein Frequenzspektrum besitzen, das oberhalb des Frequenzspektrums der Messsignale sₑ liegt. Demnach ist es möglich, diese Störungen durch einen Tiefpassfilter herauszufiltern ohne jedoch das Messsignal sₑ zu beeinflussen.

Im Einzelnen gibt es nun verschiedene Möglichkeiten, das erfindungsgemäße Messsystem auszugestalten und weiterzubilden. Dazu wird verwiesen auf die dem Patentanspruch 1 nachgeordneten Patentansprüche und auf das nachfolgend beschriebene und in der nur eine Figur enthaltenen Zeichnung dargestellte Ausführungsbeispiel.

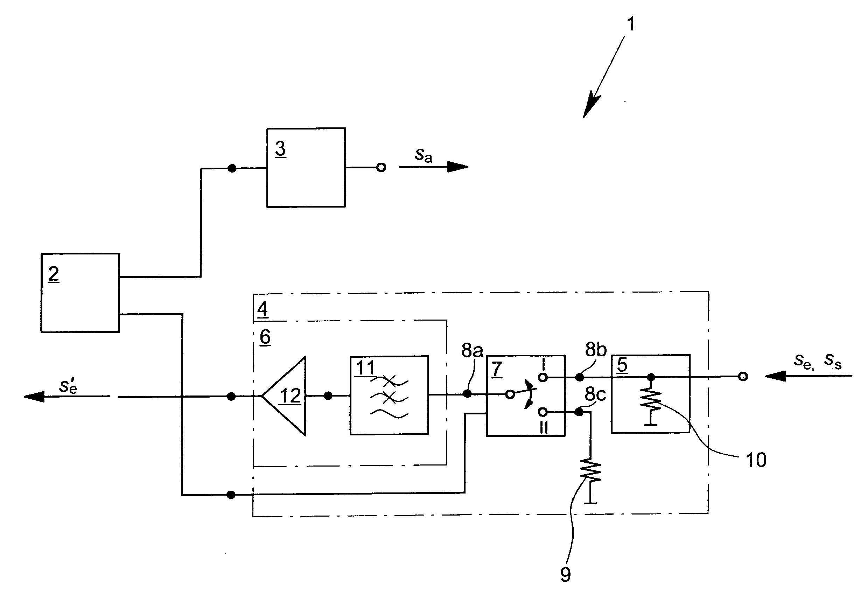

In der Zeichnung sind die wesentlichen Elemente eines erfindungsgemäßen Messsystems 1 für kernmagnetische Messgeräte schematisch dargestellt. Die wesentlichen Elemente sind eine Steuerung 2, ein Signalgenerator 3 zum Erzeugen und Ausgeben von elektrischen Anregungssignalen sₐ und eine Signalverarbeitung 4. Die Signalverarbeitung 4 umfasst im Wesentlichen eine Eingangsstufe 5, eine Signalkonditionierung 6 und einen Schalter 7, der als einpoliger Wechselschalter ausgeführt ist. Der Schalter 7 weist einen Mittelanschluss 8a, einen ersten Anschluss 8b und einen zweiten Anschluss 8c auf. Der Mittelanschluss 8a ist mit dem Eingang der Signalkonditionierung 6 verbunden, der erste Anschluss 8b ist mit dem Ausgang der Eingangsstufe 5 verbunden, und der zweite Anschluss 8c ist über einen ohmschen Spiegelwiderstand mit dem Massepotential verbunden.

Der Schalter leitet im ersten Schaltzustand I das Signal am Ausgang der Eingangsstufe 5 an den Eingang der Signalkonditionierung 6, und im zweiten Schaltzustand II ist der Eingang der Signalkonditionierung 6 über einen Spiegelwiderstand 9 mit dem Massepotential verbunden. Der Schalter 7 wird durch die Steuerung 2 entweder in den ersten Schaltzustand I oder in den zweiten Schaltzustand II gebracht. Der Signalpfad der Eingangsstufe 5 ist über einen ohmschen Abschlusswiderstand 10 ebenfalls mit Massepotential verbunden. Sowohl der Abschlusswiderstand 10 als auch der Spiegelwiderstand 9 haben einen Widerstandswert von 50 Ohm. Dieser Widerstandswert entspricht dem Leitungswellenwiderstand der Leitung, welche das Messsignal sₑ zum Eingang der Eingangsstufe leitet. Durch den gewählten Widerstandswert des Abschlusswiderstands werden Reflektionen des Messsignals sₑ am Eingang der Eingangsstufe 5 vermieden. Durch die Wahl des Widerstandswerts des Abschlusswiderstands 10 und des Widerstandswerts des Spiegelwiderstands 9 zu jeweils 50 Ohm ist der Widerstandswert am Mittelanschluss 8a des Schalters 7 unabhängig vom Schaltzustand immer 50 Ohm. Auf diese Weise werden Störungen am Eingang der Signalkonditionierung 6 vermieden. Die Signalkonditionierung 6 umfasst im Wesentlichen einen Tiefpassfilter 11 und einen Verstärker 12. Der Tiefpassfilter 11 ist zwischen dem Eingang der Signalkonditionierung 6 und dem Eingang des Verstärkers 12 angeordnet. Die Grenzfrequenz des Tiefpassfilters 11 ist derart gewählt, dass Störungen durch das Umschalten des Schalters 7 herausgefiltert werden. Jedoch ist die Grenzfrequenz auch so gewählt, dass die Messsignale sₑ nicht beeinträchtigt werden. Die konditionierten Messsignale sₑ sind zur weiteren Verarbeitung, z. B. zur Digitalisierung, weitergeleitet.

### Bezugszeichen:

- 1: Messsystem
- 2: Steuerung
- 3: Signalgenerator
- 4: Signalverarbeitung
- 5: Eingangsstufe
- 6: Signalkonditionierung
- 7: Schalter
- 8a: Mittelanschluss
- 8b: erste Anschluss
- 8c: zweite Anschluss
- 9: Spiegelwiderstand
- 10: Abschlusswiderstand
- 11: Tiefpassfilter
- 12: Verstärker

## Patentansprüche

1. Messsystem (1) für kernmagnetische Messgeräte mit einer Steuerung (2), einem Signalgenerator (3) zum Erzeugen und Ausgeben von elektrischen Anregungssignalen und einer Signalverarbeitung (4) mit einer Eingangsstufe (5) und einer auf die Eingangsstufe (5) im Signalpfad der Signalverarbeitung (4) folgenden Signalkonditionierung (6) zur Verarbeitung der von den Anregungssignalen hervorgerufenen und am Eingang der Eingangsstufe (5) eingehenden elektrischen Messsignale, wobei auch von den Anregungssignalen hervorgerufene und nicht zeitgleich mit den Messsignalen auftretende Störsignale am Eingang der Eingangsstufe (5) eingehen können, der Signalhub der Messsignale kleiner ist als der Signalhub der Störsignale und die Steuerung (2) die Zeitpunkte des Ausgebens der Anregungssignale bestimmt, wobei im Signalpfad der Signalverarbeitung (4) zwischen dem Ausgang der Eingangsstufe (5) und dem Eingang der Signalkonditionierung (6) ein Schalter (7) angeordnet ist, der Schalter (7) durch die Steuerung (2) in einen ersten Schaltzustand I und einen zweiten Schaltzustand II schaltbar ist, im ersten Schaltzustand I das Signal am Ausgang der Eingangsstufe (5) an den Eingang der Signalkonditionierung (6) geleitet ist und im zweiten Schaltzustand II das Signal am Ausgang der Eingangsstufe (5) nicht an den Eingang der Signalkonditionierung (6) geleitet ist, wobei die Steuerung (2) ausgebildet ist, den Schalter (7) nur in den Zeiträumen in den ersten Schaltzustand I zu schalten, in denen keine Störsignale am Eingang der Eingangsstufe (5) anliegen, und dass der Aussteuerbereich des Eingangs der Signalkonditionierung (6) an den Spannungshub der Messsignale angepasst ist,
**dadurch gekennzeichnet,**
**dass** der Schalter (7) ein einpoliger Wechselschalter mit einem Mittelanschluss (8a), einem ersten Anschluss (8b) und einem zweiten Anschluss (8c) ist, der Mittelanschluss (8a) mit dem Eingang der Signalkonditionierung (6) verbunden ist, der erste Anschluss (8b) mit dem Ausgang der Eingangsstufe (5) zur Leitung des Signals am Ausgang der Eingangsstufe (5) an den Eingang der Signalkonditionierung (6) im ersten Schaltzustand I verbunden ist und der zweite Anschluss (8c) über einen ohmschen Spiegelwiderstand (9) mit einem konstanten Potential zur Verbindung des Eingangs der Signalkonditionierung (6) mit dem Spiegelwiderstand (9) im zweiten Schaltzustand II verbunden ist.

2. Messsystem nach Anspruch 1, dadruch gekennzeichnet, dass die Zeiträume, in denen die Störsignale nicht am Eingang der Eingangsstufe (5) anliegen, unter Berücksichtigung des Zeitraums zwischen dem Zeitpunkt des Ausgebens eines der Anregungssignale aus dem Signalgenerator (3) und dem Zeitpunkt des Eintreffens des von dem Anregungssignal hervorgerufenen Störsignals am Eingang der Eingangsstufe (5) bestimmt sind.

3. Messsystem nach Anspruch 1 oder 2, **dadurch gekennzeichnet, dass** der Signalpfad der Eingangsstufe (5) über einen ohmschen Abschlusswiderstand (10) derart mit einem konstanten Potential verbunden ist, dass der Eingangswiderstand der Eingangsstufe (5) dem Widerstandswert des Abschlusswiderstands (10) entspricht.

4. Messsystem nach einem der Ansprüche 1 bis 3, **dadurch gekennzeichnet, dass** der Widerstandswert des Spiegelwiderstands (9) und der Widerstandswert des Abschlusswiderstands (10) derart gewählt sind, dass der Widerstandswert am Mittelanschluss (8a) unabhängig vom Schaltzustand des Schalters (7) ist.

5. Messsystem nach Anspruch 3 oder 4, **dadurch gekennzeichnet, dass** der Widerstandswert des Spiegelwiderstands (9) und der Widerstandswert des Abschlusswiderstands (10) 50 Ω betragen.

6. Messsystem nach einem der Ansprüche 1 bis 5, **dadurch gekennzeichnet, dass** die Signalkonditionierung (6) im Signalpfad einen Tiefpassfilter (11) und einen Verstärker (12) aufweist und der Tiefpassfilter im Signalpfad zwischen dem Eingang der Signalkonditionierung (6) und dem Eingang des Verstärkers (12) angeordnet ist und zur Dämpfung von durch das Schalten des Schalters (7) hervorgerufenen Störungen ausgebildet ist.

## Claims

1. Measuring system (1) for nuclear magnetic measuring devices having a controller (2), a signal generator (3) for generating and outputting electric excitation signals and a signal processor (4) with an input stage (5) and a signal conditioner (6) following the input stage (5) in the signal path of the signal processor (4) for processing the electrical measuring signals effected by the excitation signals and being received at the input of the input stage (5), wherein interfering signals also effected by the excitation signals and not occurring simultaneously with the measuring signals can be received at the input of the input stage (5), the signal swing of the measuring signal being less than the signal swing of the interfering signal and the controller (2) determining the instants of time of outputting of the excitation signals, wherein a switch (7) is arranged in the signal path of the signal processor (4) between the output of the input stage (5) and the input of the signal conditioner (6), the switch (7) being switchable to a first switching state I and a second switching state II by the controller (2), the signal at the output of the input stage (5) being led to the input of the signal conditioner (6) in the first switching state I, and the signal at the output of the input stage (5) not being led to the input of the signal conditioner (6) in the second switching state II, wherein the controller (2) is designed to switch the switch (7) in the first switching state I only in the periods of time, in which there are no interfering signals at the input of the input stage (5), and that the dynamic range of the input of the signal conditioner (6) is adapted to the voltage swing of the measuring signals
**characterized in**
**that** the switch (7) is a single pole changeover switch with a middle terminal (8a), a first terminal (8b) and a second terminal (8c), the middle terminal (8a) being connected to the input of the signal conditioner (6), the first terminal (8b) being connected to the output of the input stage (5) for leading the signal at the output of the input stage (5) to the input of the signal conditioner (6) in the first switching state I and the second terminal (8c) being connected via an ohmic mirror resistor (9) to a constant potential for connecting the input of the signal conditioner (6) to the mirror resistor (9) in the second switching state II.

2. Measuring system according to claim 1, **characterized in that** the periods of time, in which there are no interfering signals at the input of the input stage (5), are determined taking consideration of the period of time between the instant of time of outputting of one of the excitation signals from the signal generator (3) and the instant of time of arrival of the interfering signal effected by the excitation signals at the input of the input stage (5).

3. Measuring system according to claim 1 or 2, **characterized in that** the signal path of the input stage (5) is connected to a constant potential via an ohmic termination resistor (10) in such a manner, that the input resistance value of the input stage (5) corresponds to the resistance value of the termination resistor (10).

4. Measuring system according to any one of claims 1 to 3, **characterized in that** the resistance value of the mirror resistor (9) and the resistance value of the termination resistor (10) are selected such that the resistance value at the middle terminal (8) is independent of the switching state of the switch (7).

5. Measuring system according to claim 3 or 4, **characterized in that** the resistance value of the mirror resistor (9) and the resistance value of the termination resistor (10) are 50 Ω.

6. Measuring system according to any one of claims 1 to 5, **characterized in that** the signal conditioner (6) has a low-pass filter (11) and an amplifier (12) in the signal path and the low-pass filter is arranged in the signal path between the input of the signal conditioner (6) and the input of the amplifier (12) and is designed to attenuate interferences effected by switching the switch (7).

## Revendications

1. Système de mesure (1) destiné à des dispositifs de mesure de résonance magnétique nucléaire comportant une unité de commande (2), un générateur de signaux (3) destiné à générer et à délivrer des signaux d'excitation électriques et une unité de traitement de signaux (4) comportant un étage d'entrée (5) et une unité de conditionnement de signaux (6) en aval de l'étage d'entrée (5) sur le trajet de signaux de l'unité de traitement de signaux (4) pour traiter les signaux de mesure électriques induits par les signaux d'excitation et appliqués à l'entrée de l'étage d'entrée (5), dans lequel des signaux parasites également induits par les signaux d'excitation et n'apparaissant par en même temps que les signaux de mesure peuvent être appliqués à l'entrée de l'étage d'entrée (5), l'excursion de signal des signaux de mesure est inférieure à l'excursion de signal des signaux parasites et l'unité de commande (2) détermine les instants où les signaux d'excitation sont délivrés, dans lequel un commutateur (7) est disposé sur le trajet de signaux de l'unité de traitement des signaux (4) entre la sortie de l'étage d'entrée (5) et l'entrée de l'unité de conditionnement de signaux (6), le commutateur (7) peut être commuté par l'unité de commande (2) dans un premier état de commutation I et un deuxième état de commutation II, dans le premier état de commutation I, le signal à la sortie de l'étage d'entrée (5) est acheminé vers l'entrée de l'unité de conditionnement de signaux (6) et dans le deuxième état de commutation II, le signal à la sortie de l'étage d'entrée (5) n'est pas acheminé vers l'entrée de l'unité de conditionnement de signaux (6), dans lequel l'unité de commande (2) est conçue pour ne commuter le commutateur (7) que pendant l'intervalle de temps correspondant à l'état de commutation I dans lequel aucun signal parasite n'est appliqué à l'entrée de l'étage d'entrée (5), et dans lequel le domaine de commande de l'entrée de l'unité de conditionnement de signaux (6) est adaptée à l'excursion de tension des signaux de mesure,
**caractérisé en ce que** le commutateur (7) est un inverseur va-et-vient unipolaire ayant un raccord central (8a), une première borne (8b) et une deuxième borne (8c), la borne centrale (8a) est connectée à l'entrée de l'unité de conditionnement de signaux (6), la première borne (8b) est connectée à la sortie de l'étage d'entrée (5) afin d'acheminer le signal vers la sortie de l'étage d'entrée (5) à l'entrée de l'unité de conditionnement de signaux (6) dans le premier état de commutation I et la deuxième borne (8c) est connectée par l'intermédiaire d'une résistance miroir ohmique (9) à un potentiel constant afin de connecter l'entrée de l'unité de conditionnement de signaux (6) à la résistance miroir (9) dans le deuxième état de commutation II.

2. Système de mesure selon la revendication 1, **caractérisé en ce que** les intervalles de temps pendant lesquels les signaux parasites ne sont pas appliqués à l'entrée de l'étage d'entrée (5) sont déterminés en tenant compte de l'intervalle de temps séparant l'instant où l'un des signaux d'excitation est délivré en sortie du générateur de signaux (3) de l'instant où le signal parasite induit par le signal d'excitation est appliqué en entrée de l'étage d'entrée (5).

3. Système de mesure selon la revendication 1 ou 2, **caractérisé en ce que** le trajet de signaux de l'étage d'entrée (5) est connecté par l'intermédiaire d'une résistance de terminaison ohmique (10) à un potentiel constant de manière à ce que la résistance d'entrée de l'étage d'entrée (5) corresponde à la valeur de la résistance de terminaison (10).

4. Système de mesure selon l'une quelconque des revendications 1 à 3, **caractérisé en ce que** la valeur de la résistance miroir (9) et la valeur de la résistance de terminaison (10) sont sélectionnées de manière à ce que la valeur de la résistance au niveau de la borne centrale (8a) soit indépendante de l'état de commutation du commutateur (7).

5. Système de mesure selon la revendication 3 ou 4, **caractérisé en ce que** la valeur de la résistance miroir (9) et la valeur de la résistance de terminaison (10) sont égales à 50 Ω.

6. Système de mesure selon l'une quelconque des revendications 1 à 5, **caractérisé en ce que** l'unité de conditionnement de signaux (6) comporte sur le trajet de signaux un filtre passe-bas (11) et un amplificateur (12) et **en ce que** le filtre passe-bas est disposé sur le trajet de signaux entre l'entrée de l'unité de conditionnement de signaux (6) et l'entrée de l'amplificateur (12) et est conçu pour amortir les parasites induits par la commutation du commutateur (7).
